# EUROPÄISCHE PATENTANMELDUNG

(11) **EP 4 012 061 A1**
(43) Veröffentlichungstag der Anmeldung: **15.06.2022**
(21) Anmeldenummer: 20212826.0
(22) Anmeldetag: 09.12.2020
(51) Int. Cl.: C22C 19/05, F01D 5/28, C30B 11/14, C30B 29/52, B22D 21/00, B22D 27/04

(54) **NICKELBASISLEGIERUNG UND BAUTEIL AUS DIESER**

(71) Anmelder: MTU Aero Engines AG, 80995 München (DE)
(72) Erfinder: Schwalbe, Casper, 80995 München (DE); Dr. Göhler, Thomas, 80995 München (DE); Sowa, Roman, 80995 München (DE); Futoma, Magdalena, 80995 München (DE)

(57) **Zusammenfassung**

Nickelbasislegierung für Hochtemperaturanwendungen, insbesondere zur Verwendung in Strömungsmaschinen, mit einer chemischen Zusammensetzung umfasst: 5,9 bis 6,3 Gew.% Al, 4 bis 8 Gew.% Co, 5,5 bis 7,5 Gew.% Cr, 0 bis 0,8 Gew.% Hf, 0 bis 1,25 Gew.% Mo, 1 bis 2 Gew.% Re, 6 bis 7,5 Gew.% Ta, 4,5 bis 7 Gew.% W, 0,01 bis 1 Gew.% C, 0 bis 0,4 Gew.% Ti, 0 bis 0,01 Gew.% B, 0 bis 0,08 Gew.% Y, 0 bis 0,5 Gew.% Zr, 0 bis 0,8 Gew.% Nb und Rest Nickel sowie unvermeidbare Verunreinigungen.

## Beschreibung

### HINTERGRUND DER ERFINDUNG

### GEBIET DER ERFINDUNG

Die Erfindung betrifft eine Nickelbasislegierung, insbesondere eine Nickelbasis-Superlegierung für Hochtemperaturanwendungen, vorzugsweise zur Verwendung in Strömungsmaschinen, wie Flugtriebwerken, sowie ein entsprechendes Bauteil einer Strömungsmaschine, insbesondere eines Flugtriebwerks aus einer derartigen Nickelbasislegierung.

Unter Nickelbasislegierung ist ein Werkstoff zu verstehen, der im Hauptbestandteil Nickel aufweist. Eine besondere Ausgestaltung von Nickelbasislegierungen stellen Nickelbasis - Superlegierungen dar, unter denen Legierungen zu verstehen sind, die durch ihre besondere Zusammensetzung und Gefügeausbildung bei hohen Temperaturen bis nahe zu ihrem Schmelzpunkt einsetzbar ist. Der Begriff der Nickelbasislegierung, wie er nachfolgend verwendet wird, umfasst somit auch den Begriff der Nickelbasis-Superlegierung.

### STAND DER TECHNIK

Nickelbasis - Superlegierungen werden bei Hochtemperaturanwendungen, z. B. beim Bau von stationären Gasturbinen oder Flugtriebwerken, aufgrund ihrer Hochtemperaturfestigkeit eingesetzt. Unter Hochtemperaturanwendung wird hierbei eine Anwendung verstanden, bei der die Einsatztemperatur eines aus der Legierung hergestellten Bauteils in einem Temperaturbereich oberhalb der halben Schmelztemperatur der Legierung liegt.

Die Nickelbasis - Superlegierungen verdanken ihre guten Hochtemperatureigenschaften und insbesondere ihre hervorragende Hochtemperaturfestigkeit einer speziellen Gefügeausbildung, die durch eine γ - Matrix und darin eingelagerte γ' - Ausscheidungen gekennzeichnet ist.

Aus dem Stand der Technik sind Nickelbasis - Superlegierungen mit unterschiedlichen Zusammensetzungen bekannt, wie beispielsweise aus dem Dokument EP3133178A1.

Für bestehende und zukünftige Anwendungen sind Legierungen, die hinsichtlich ihrer Eigenschaften, Verfügbarkeit und/oder Nachhaltigkeit Verbesserungen aufweisen, wünschenswert.

Insbesondere bei Flugtriebwerken gibt es aufgrund des bestehendes Wunsches zu höheren Drehzahlen und Temperaturen im Turbinenbereich, insbesondere im Bereich von ungekühlten Niederdruckturbinenschaufeln, insbesondere bei Temperaturen bis zu 1100°C, einen Bedarf an geeigneten, herstellbaren und verfügbaren hochtemperaturstabilen Legierungen.

### OFFENBARUNG DER ERFINDUNG

### AUFGABE DER ERFINDUNG

Es ist Aufgabe der vorliegenden Erfindung, eine Nickelbasislegierung und ein Bauteil bereitzustellen, die besonders Vorteilhaft in Bezug auf ihre Eigenschaften, Verfügbarkeit und Nachhaltigkeit sind.

### TECHNISCHE LÖSUNG

Diese Aufgabe wird gelöst durch eine Nickelbasislegierung mit den Merkmalen des Anspruchs 1, ein Bauteil gemäß Anspruch 6 sowie ein Verfahren nach Anspruch 10. Vorteilhafte Ausgestaltungen sind Gegenstand der abhängigen Ansprüche.

Eine Nickelbasislegierung hat gemäß der vorliegenden Erfindung eine chemische Zusammensetzung mit 5,9 bis 6,3 Gew.% Al, 4 bis 8 Gew.% Co, 5,5 bis 7,5 Gew.% Cr, 0 bis 0,8 Gew.% Hf, 0 bis 1,25 Gew.% Mo, 1 bis 2 Gew.% Re, 6 bis 7,5 Gew.% Ta, 4,5 bis 7 Gew.% W, 0,01 bis 1 Gew.% C, 0 bis 0,4 Gew.% Ti, 0 bis 0,01 Gew.% B, 0 bis 0,08 Gew.% Y, 0 bis 0,5 Gew.% Zr, 0 bis 0,8 Gew.% Nb und Rest Nickel sowie unvermeidbare Verunreinigungen.

Die Legierung kommt mit einem besonders geringem Rheniumgehalt aus. Rhenium ist selten, in vergleichsweise geringem Umfang verfügbar und stellt Herausforderungen an eine nachhaltige Primärgewinnung. Ein geringer Re-Gehalt kann über eine Sekundärbeschaffung gedeckt werden und bringt damit Vorteile in der Nachhaltigkeit mit sich.

Zwar hat Rhenium hat einen besonders vorteilhaften Effekt auf die Hochtemperaturstabilität, wie Kriechfestigkeit, LCF und HCF. Erfindungsgemäß kann ein geringer Rheniumgehalt, der 2 Gew.% nicht übersteigt, jedoch durch die oben angegebene Ausbalancierung der weiteren Elemente Mo, Ta, Ti und optional Nb ausgeglichen werden.

Die Legierungszusammensetzung ermöglicht einen ausreichend hohen Anteil der γ' - Ausscheidungen, insbesondere von über 60 vol.% bei 800°C. Die γ' - Ausscheidungen sind insbesondere für die Hochtemperaturstabilität besonders wichtig.

Gleichzeitig ermöglicht die Legierungszusammensetzung einen vorteilhaft geringen Sprödphasenanteil.

Weiterhin kann die Legierungszusammensetzung eine hinreichende Gießbarkeit bzw. Herstellbarkeit in der erforderlichen Homogenität in der Mikrostruktur des Gefüges zuverlässig sicherstellen.

Gemäß einer Ausführung hat die Nickelbasislegierung eine chemische Zusammensetzung mit 5,9 bis 6,3 Gew.% Al, 7 bis 8 Gew.% Co, 5,5 bis 7,5 Gew.% Cr, 0,45 bis 0,68 Gew.% Hf, 0,65 bis 1,15 Gew.% Mo, 1,4 bis 1,7 Gew.% Re, 6,2 bis 7,2 Gew.% Ta, 5,5 bis 7 Gew.% W, 0,02 bis 0,07 Gew.% C, 0 bis 0,2 Gew.% Ti, 0 bis 0,008 Gew.% B, 0 bis 0,04 Gew.% Y, 0 bis 0,016 Gew.% Zr, 0 bis 0,25 Gew.% Nb und Rest Nickel sowie unvermeidbare Verunreinigungen. Hierdurch kann der geringe Rheniumgehalt besonders vorteilhaft ausgeglichen werden.

Gemäß einer Ausführung hat die Nickelbasislegierung eine chemische Zusammensetzung mit 5,9 bis 6,3 Gew.% Al, 7 bis 8 Gew.% Co, 5,5 bis 7,5 Gew.% Cr, 0,45 bis 0,68 Gew.% Hf, 0,65 bis 1,15 Gew.% Mo, 1,4 bis 1,7 Gew.% Re, 6,2 bis 7,2 Gew.% Ta, 5,5 bis 7 Gew.% W, 0,02 bis 0,07 Gew.% C, 0 bis 0,2 Gew.% Ti, 0 bis 0,008 Gew.% B, 0 bis 0,04 Gew.% Y, 0 bis 0,016 Gew.% Zr, 0,05 bis 0,25 Gew.% Nb und Rest Nickel sowie unvermeidbare Verunreinigungen.

Gemäß einer Ausführung ist die Nickelbasislegierung eine einkristalline Superlegierung, insbesondere mit einer kubisch flächenzentrierten Kristallstruktur.

Die Legierung umfasst vorzugsweise eine γ - Matrix und γ' - Ausscheidungen, wobei der Anteil an γ' - Ausscheidungen in der Legierung im Temperaturbereich zwischen 850°C und 1100°C insbesondere über 60 Vol.% beträgt. Dadurch kann eine besonders hohe Temperaturstabilität im Bereich zwischen 850°C und 1100°C erreicht werden.

Die vorliegende Erfindung umfasst zudem auch ein Bauteil einer Strömungsmaschine, insbesondere eines Flugtriebwerks, welches eine Nickelbasislegierung nach einer zuvor genannten Ausführung umfasst oder daraus besteht.

Das Bauteil kann eine Leit- oder Laufschaufel sein, insbesondere für eine Turbinenstufe, insbesondere Niederdruckturbinenstufe, eines Flugtriebwerks.

Im Bauteil kann die Nickelbasislegierung einkristallin oder gerichtet erstarrt ausgebildet sein, insbesondere derart, dass die [001]-Kristallrichtung in der hergestellten Leit- oder Laufschaufel um höchstens 15° von der sich in Radialrichtung erstreckenden Schaufelachse abweicht.

Die Turbinenstufe kann mittels eines Getriebes mit einem Fan der des Flugtriebwerks gekoppelt sein. Die Turbine kann dabei im Betrieb schneller drehen als der Fan.

Die vorliegende Erfindung umfasst weiterhin ein Verfahren zur Herstellung eines Bauteils nach einer vorgenannten Ausführung, welches den folgenden Schritt umfasst: Gießen einer Schmelze mit einer chemischen Zusammensetzung einer vorgenannten Legierung in eine Gussform für eine Leit- oder Laufschaufel mit einer jeweiligen Schaufelachse in Radialrichtung, wobei die Gussform einen Impfkristall oder sog. "Starter" umfasst, der eine [001]-Kristallrichtung für ein einkristallines Kristallwachstum festlegt und derart in der Gussform orientiert angeordnet ist, dass die [001]-Kristallrichtung im hergestellten Bauteil um höchstens 15° von der Radialrichtung abweicht.

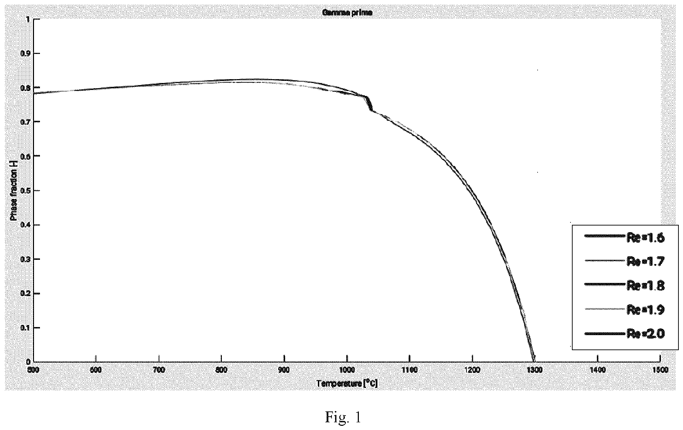

Fig. 1 zeigt für erfindungsgemäße Legierungen mit unterschiedlichen Rheniumanteilen von 1,6, 1,7 , 1,8 , 1,9 und 2,0 Gew.% gemäß einer Simulation den Anteil der γ' - Ausscheidungen. Es ist zu erkennen, dass der Anteil der γ' - Ausscheidungen bis zu hohen Temperaturen vorteilhaft hoch, insbesondere über 60 vol.% gehalten werden kann. Die Abhängigkeit vom Re-Gehalt ist dabei vorteilhaft gering.

Obwohl die vorliegende Erfindung anhand der Ausführungsbeispiele detailliert beschrieben worden ist, ist die Erfindung nicht auf diese Ausführungsbeispiele beschränkt, sondern vielmehr sind Abwandlungen in der Weise möglich, dass einzelne Merkmale innerhalb des angegebenen Schutzbereichs der beigefügten Ansprüche verändert werden können. Die Offenbarung schließt sämtliche Kombinationen der vorgestellten Einzelmerkmale mit ein.

## Patentansprüche

1. Nickelbasislegierung für Hochtemperaturanwendungen, insbesondere zur Verwendung in Strömungsmaschinen, mit einer chemischen Zusammensetzung umfasst: 5,9 bis 6,3 Gew.% Al,
4 bis 8 Gew.% Co,
5,5 bis 7,5 Gew.% Cr,
0 bis 0,8 Gew.% Hf,
0 bis 1,25 Gew.% Mo,
1 bis 2 Gew.% Re,
6 bis 7,5 Gew.% Ta,
4,5 bis 7 Gew.% W,
0,01 bis 1 Gew.% C,
0 bis 0,4 Gew.% Ti,
0 bis 0,01 Gew.% B,
0 bis 0,08 Gew.% Y,
0 bis 0,5 Gew.% Zr,
0 bis 0,8 Gew.% Nb
und Rest Nickel sowie unvermeidbare Verunreinigungen.

2. Nickelbasislegierung nach Anspruch 1 mit einer chemischen Zusammensetzung, die umfasst:
5,9 bis 6,3 Gew.% Al,
7 bis 8 Gew.% Co,
5,5 bis 7,5 Gew.% Cr,
0,45 bis 0,68 Gew.% Hf,
0,65 bis 1,15 Gew.% Mo,
1,4 bis 1,7 Gew.% Re,
6,2 bis 7,2 Gew.% Ta,
5,5 bis 7 Gew.% W,
0,02 bis 0,07 Gew.% C,
0 bis 0,2 Gew.% Ti,
0 bis 0,008 Gew.% B,
0 bis 0,04 Gew.% Y,
0 bis 0,016 Gew.% Zr,
0 bis 0,25 Gew.% Nb
und Rest Nickel sowie unvermeidbare Verunreinigungen.

3. Nickelbasislegierung nach Anspruch 2 mit einer chemischen Zusammensetzung, die umfasst:
5,9 bis 6,3 Gew.% Al,
7 bis 8 Gew.% Co,
5,5 bis 7,5 Gew.% Cr,
0,45 bis 0,68 Gew.% Hf,
0,65 bis 1,15 Gew.% Mo,
1,4 bis 1,7 Gew.% Re,
6,2 bis 7,2 Gew.% Ta,
5,5 bis 7 Gew.% W,
0,02 bis 0,07 Gew.% C,
0 bis 0,2 Gew.% Ti,
0 bis 0,008 Gew.% B,
0 bis 0,04 Gew.% Y,
0 bis 0,016 Gew.% Zr,
0,05 bis 0,25 Gew.% Nb
und Rest Nickel sowie unvermeidbare Verunreinigungen.

4. Nickelbasislegierung nach einem der vorhergehenden Ansprüche, die eine einkristalline Nickelbasis-Superlegierung ist, insbesondere mit einer kubisch flächenzentrierten Kri stall struktur.

5. Nickelbasislegierung nach einem der vorhergehenden Ansprüche, die Legierung eine γ - Matrix und γ' - Ausscheidungen umfasst, wobei der Anteil an γ' - Ausscheidungen in der Legierung im Temperaturbereich zwischen 850°C und 1100°C über 60 Vol.% beträgt.

6. Bauteil einer Strömungsmaschine, insbesondere eines Flugtriebwerks, welches eine Nickelbasislegierung nach einem der vorhergehenden Ansprüche umfasst oder daraus besteht.

7. Bauteil nach Anspruch 6, das eine Leit- oder Laufschaufel ist, insbesondere für eine Turbinenstufe, insbesondere Niederdruckturbinenstufe, eines Flugtriebwerks ist.

8. Bauteil nach Anspruch 6 oder 7, wobei die Nickelbasislegierung einkristallin oder gerichtet erstarrt ausgebildet ist, insbesondere derart, dass die [001]-Kristallrichtung in der hergestellten Leit- oder Laufschaufel um höchstens 15° von der sich in Radialrichtung erstreckenden Schaufelachse abweicht.

9. Bauteil nach Anspruch 7 oder 8, wobei die Turbinenstufe mittels eines Getriebes mit einem Fan der des Flugtriebwerks gekoppelt ist, und die Turbine im Betrieb schneller dreht als der Fan.

10. Verfahren zur Herstellung eines Bauteils nach einem der Ansprüche 6 bis 9, welches den folgenden Schritt umfasst: Gießen einer Schmelze mit einer chemischen Zusammensetzung einer Legierung nach einem der Ansprüche 1 bis 5 in eine Gussform für eine Leit- oder Laufschaufel mit einer jeweiligen Schaufelachse in Radialrichtung, wobei die Gussform einen Impfkristall oder sog. "Starter" umfasst, der eine [001]-Kristallrichtung für ein einkristallines Kristallwachstum festlegt und derart in der Gussform orientiert angeordnet ist, dass die [001]-Kristallrichtung im hergestellten Bauteil um höchstens 15° von der Radialrichtung abweicht.
